# FASCICULE DE BREVET EUROPEEN

(11) **EP 0 321 899 B1**
(45) Date de publication et mention de la délivrance du brevet: **22.03.1995**
(21) Numéro de dépôt: 88121209.6
(22) Date de dépôt: 19.12.1988
(51) Int. Cl.: H01L 23/36, H01L 21/60

(54) **Procédé et dispositif de refroidissement d'un boîtier de circuit intégré**
Verfahren und Kühlungsanordnung für ein Gehäuse einer integrierten Schaltung
Method and cooling device for an integrated-circuit housing

(30) Priorité: 22.12.1987 FR 8717920
(43) Date de publication de la demande: 28.06.1989
(73) Titulaire: ALCATEL CIT, 75008 Paris (FR)
(72) Inventeur: Septfons, René, F-75012 Paris (FR)
(74) Mandataire: Weinmiller, Jürgen

(56) Documents cités:
- EP-A- 0 023 534
- EP-A- 0 129 966
- EP-A- 0 139 431
- EP-A- 0 180 730
- DE-A- 1 414 466
- GB-A- 1 084 028
- US-A- 4 420 767
- PATENT ABSTRACTS OF JAPAN, vol. 9, no. 136 (E-320)[1859], 12 June 1985 ; & JP-A-60 18 985

## Description

La présente invention est relative au refroidissement des boîtiers de circuit intégré, notamment ceux destinés à être montés en surface dans des circuit hybrides qui sont des assemblages sous forte densité de composants électroniques sur un support plat appelé substrat constitué en général d'une mince plaquette de céramique recouverte sur une ou deux faces d'un réseau imprimé de résistances et pistes conductrices protégé ou non par une couche isolante vitrifiée et de plots étamables aboutissant aux pistes et servant à la fixation et aux raccordements des composants et des broches de connexion du circuit hydride avec l'environnement extérieur.

Les boîtiers de circuit intégré prévus pour ce genre d'utilisation sont constitués, en général, d'une coupelle en céramique fermée par un couvercle métallique et pourvue sur son pourtour de plots extérieurs de connexion pour montage en surface reliés par des traversées franchissant la paroi de la coupelle à des plots intérieurs de connexion raccordés à une puce de circuit intégré fixée par brasure sur une plage métallisée réalisée à l'intérieur du fond de la coupelle.

Pour refroidir cette sorte de boîtier de circuit intégré, il est connu de coller ou de clipser une pièce métallique de dissipation thermique sur l'extérieur du fond de leur coupelle en céramique qui est en contact thermique direct avec la puce de circuit intégré et de monter le boîtier à l'envers sur le substrat d'un circuit hydride. Cette solution à l'inconvénient de faire supporter la masse du radiateur par le boîtier du circuit intégré et donc de le fragiliser ainsi que les soudures de ses plots extérieurs de connexion avec ceux des pistes du substrat. Elle a également pour inconvénient de ne pas permettre l'utilisation du substrat comme dissipateur thermique et d'augmenter notablement l'encombrement en hauteur du circuit hybride qui, d'une manière générale, est déjà monté en élévation sur un circuit imprimé.

La présente invention a pour but d'éviter ces inconvénients.

Il est par ailleurs connu, du document EP-A-0180730, de refroidir un boîtier de circuit intégré pour montage sur un substrat, au moyen d'un dissipateur thermique, ledit boîtier et ledit dissipateur thermique étant fixés sur ledit substrat à un même emplacement de part et d'autre. Dans ce document une pièce intermédiaire de transfert de chaleur est cependant nécessaire entre ledit boîtier et ledit dissipateur thermique. La présente invention permet également d'éviter une telle pièce intermédiaire de transfert de chaleur.

La présente invention a pour objet un procédé de refroidissement d'un boîtier de circuit intégré pour montage sur un substrat, au moyen d'un dissipateur thermique, ledit boîtier et ledit dissipateur thermique étant fixés sur ledit substrat à un même emplacement de part et d'autre de celui-ci, et ledit procédé étant décrit dans la revendication 1 et essentiellement caractérisé en ce qu'il consiste à:
- pourvoir la surface extérieure du fond du boîtier d'une plage étamable permettant sa fixation par brasure,
- pourvoir le substrat, dans la zone de positionnement du boîtier, de deux plages étamables venant en vis-à-vis sur chacune de ses faces, la première plage étamable étant placée en regard de celle du fond du boîtier et la deuxième plage étamable communiquant avec la première par l'intermédiaire d'au moins un trou à paroi métallisée percé au travers du substrat,
- étamer lesdites plages étamables, le ou les trous à paroi métallisée se remplissant alors de brasure,
- braser simultanément, sur le substrat, le fond du boîtier de circuit intégré au moyen des plages étamables venant en regard et, sous le substrat, au niveau du boîtier de circuit intégré, un pion dissipateur thermique pourvu d'une surface étamable permettant son brasage sur la deuxième plage étamable du substrat et percé d'au moins un canal métallique se terminant à une extrémité par un capillaire débouchant dans la surface étamable et à l'autre extrémité par un réservoir de brasure, ce canal permettant d'absorber par l'intermédiaire du ou des trous à paroi métallisée tout excès de brasure entre le fond du boîtier de circuit intégré et le substrat.

Dans le cas où le substrat suffit à dissiper la chaleur engendrée par le boîtier du circuit intégré, le pion est configuré pour n'avoir qu'une faible surface en contact avec le substrat de manière à pouvoir en être séparé facilement, après brasage et absorption d'un éventuel excès de brasure entre le fond du boîtier de circuit intégré et le substrat, par simple cassure de la brasure qui le fixe au substrat.

L'invention a également pour objet un dispositif de refroidissement pour la mise en oeuvre du procédé précité, quel dispositif est décrit dans la revendication 3.

L'interposition du substrat entre le boîtier du circuit intégré et le pion métallique de dissipation thermique évite, lorsque ce dernier n'est pas enlevé, le report de tout effort mécanique sur le boîtier du circuit intégré ou sur les soudures de ses plots extérieurs de connexion. En outre, le refroidissement du boîtier de circuit intégré par le seul substrat ou au moyen d'un pion métallique brasé sous le substrat permet de réduire l'encombrement final du circuit hybride une fois monté en élévation sur un circuit imprimé car le pion se loge, au travers d'un trou prévu dans le circuit imprimé, dans une hauteur de dégagement de toute façon réservée à ce dernier.

Le brasage du boîtier de circuit intégré sur le substrat apporte un bien meilleur contact thermique entre les deux qu'un simple collage ou qu'un assemblage par clips mais pose, en contre-partie, un problème d'excès de brasure dont la quantité d'apport, lors de l'étamage du substrat, est difficilement maîtrisable et qui peut provoquer soit une mise à niveau incorrecte du boîtier de circuit intégré sur le substrat empêchant le brasage de tous ses plots extérieurs de connexion avec ceux des pistes du substrat, soit des ponts de court-circuit entre lesdits plots. Ce problème est résolu par le brasage simultané avec celui du boîtier, d'un pion de l'autre côté du substrat, qui est percé d'au moins un canal à paroi métallique se terminant à une extrémité par un capillaire debouchant dans sa surface étamable et venant au voisinage du trou à paroi métallisée du substrat, et à l'autre extrémité par un réservoir de brasure, ce canal permettant d'absorber tout excès de brasure entre le fond du boîtier et le substrat.

Ce pion permet ainsi de pomper l'excès de brasure au travers du ou des trous à paroi métallisée du substrat grâce aux phénomènes de tension superficielle agissant sur la brasure dans la partie capillaire de son ou de ses canaux, et est maintenu en excellent contact thermique avec le boîtier du circuit intégré par l'intermédiaire de la brasure.

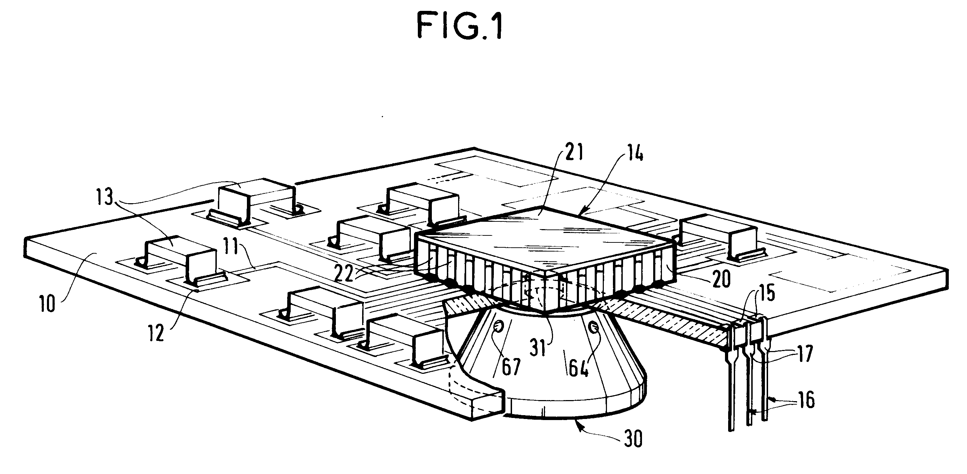

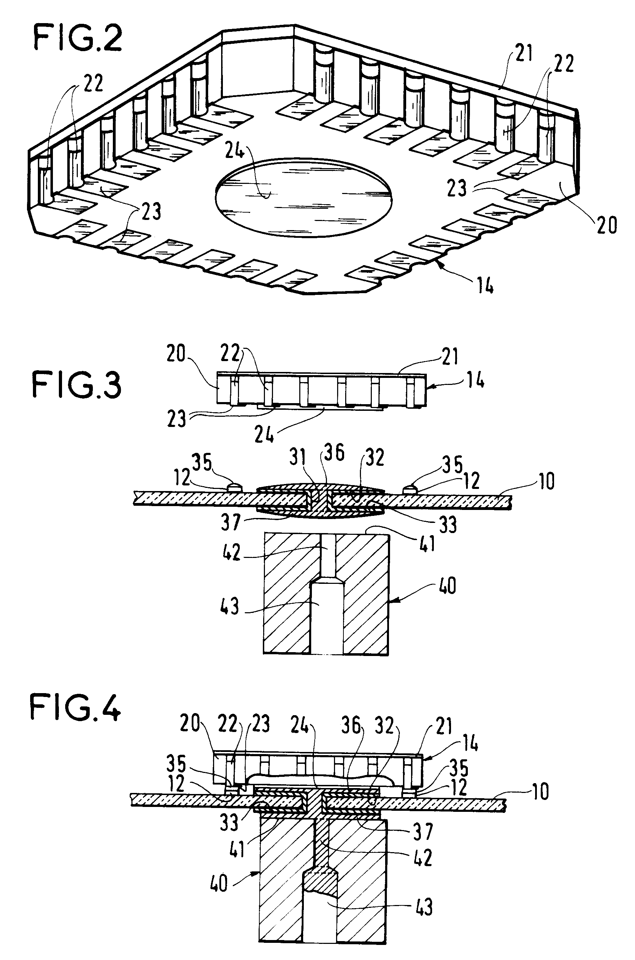

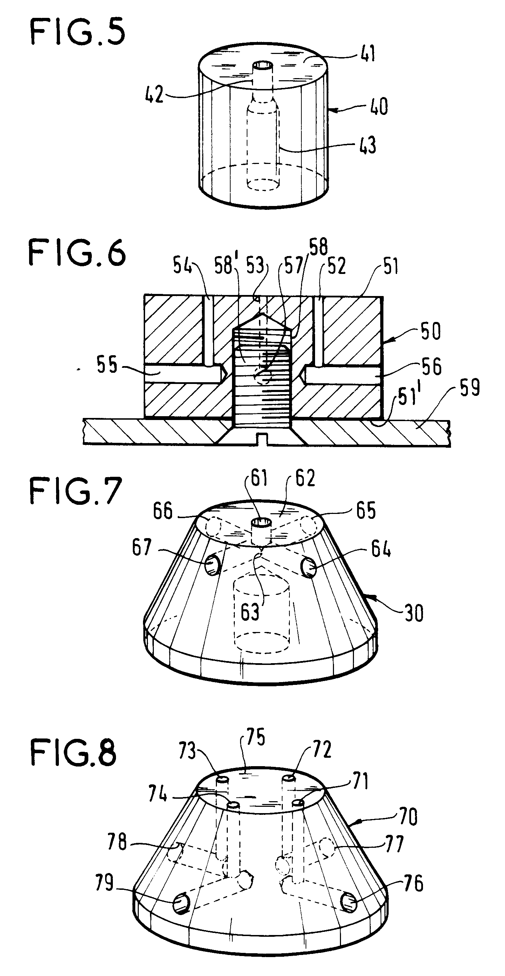

D'autres caractéristiques et avantages de l'invention ressortiront de la description ci-après de plusieurs modes de réalisation donnés à titre d'exemple. Cette description sera faite en regard du dessin dans lequel :
- une figure 1 est une vue schématique, en perspective partiellement déchirée, d'un circuit hybride équipé d'un boîtier de circuit intégré monté avec un dispositif de refroidissement conforme à l'invention,
- une figure 2 est une vue de dessous, en perspective, du boîtier de circuit intégré visible à la figure 1,
- une figure 3 est une vue en coupe partielle présentant le boîtier de circuit intégré avec un dispositif de refroidissement conforme à l'invention avant leur brasage au substrat,
- une figure 4 est une vue en coupe partielle présentant le boîtier de circuit intégré et son dispositif de refroidissement après leur brasage au substrat
- une figure 5 représente, en perspective, le dispositif de refroidissement vu en coupe aux figures 3 et 4,
- une figure 6 représente, en coupe, une variante du dispositif de refroidissement montré aux figures 3, 4 et 5, et
- des figures 7 et 8 montrent, en perspective, deux autres variantes tronconiques de dispositif de refroidissement.

On distingue, sur la figure 1, un circuit hybride avec son substrat 10 supportant un réseau imprimé de résistances et de pistes conductrices 11 menant à des plots étamables de connexion 12 pour composants électroniques à montage en surface 13 dont un boîtier 14 de circuit intégré et à des plots de connexion 15 de bord auxquels sont soudées des broches 16 de raccordement électrique du circuit hybride avec l'extérieur.

Le substrat 10 est une mince plaquette de céramique recouverte par sérigraphie, sur l'une de ses faces ou sur les deux, du réseau de résistances et de pistes conductrices 11 éventuellement protégé par une couche isolante vitrifiée, non représentée, à l'exception des plots de connexion 12, 15 laissés accessibles pour l'étamage.

Le boîtier 14 du circuit intégré pour montage en surface est formé d'une coupelle rectangulaire 20 en céramique fermée par un couvercle métallique 21 et pourvue sur son pourtour de plots extérieurs de connexion 22 se prolongeant en dessous par des sabots de contact rectangulaires 23 visibles sur la figure 2.

Les broches 16 ont une tête 17 équipée de griffes leur permettant de se monter sur la tranche du substrat 10 au niveau des plots de connexion de bord 15. Dirigées perpendiculairement au substrat 10, elles permettent de monter ultérieurement le circuit hybride sur un circuit imprimé de plus grande surface, en légère surélévation par rapport à celui-ci.

Les éléments du circuit hybride considéré sont assemblés selon la technique bien connue dite par refusion qui consiste à étamer le substrat 10 à l'état nu ce qui provoque la formation de dômes de brasure sur ses plots de connexion 12, 15, à positionner les composants et les broches sur le substrat 10, leurs plots de connexion en contact avec les dômes de brasure de ceux du substrat 10, à les maintenir en place par collage ou avec l'aide d'un support provisoire, et à réaliser en une seule fois toutes les brasures en chauffant l'ensemble jusqu'à refusion des dômes de brasure du substrat et à la migration de la brasure par capillarité sur les plots des composants et sur les griffes des broches.

Outre les composants électroniques habituels, un pion métallique 30 de forme tronconique constituant un dissipateur thermique est disposé sous la face inférieure du substrat 10, au niveau de l'emplacement du boîtier 14 de circuit intégré. Lors de l'opération de refusion, ce pion métallique est brasé au substrat 10, simultanément avec le fond du boîtier 14 de circuit intégré et les autres éléments, grâce à trois plages étamables non visibles sur la figure 1, l'une placée au centre de la surface extérieure du fond du boîtier 14 de circuit intégré et les deux autres placées en vis-à-vis sur les deux faces du substrat 10.

La figure 2 montre l'extérieur de fond de la coupelle rectangulaire 20 du boîtier 14 de circuit intégré avec, sur son pourtour, les sabots rectangulaires de contact 23 qui prolongent les plots extérieurs de connexion 22 encastrés dans la paroi latérale de la coupelle 20 et qui sont destinés à être brasés à des plots de connexion 12 du substrat, et en son milieu, une plage étamable 24 représentée ici circulaire qui est isolée des sabots rectangulaires de contact 23 et destinée à permettre le brasage du fond de la coupelle 20 sur le substrat 10.

La figure 3 représente une coupe du substrat 10 au niveau d'un trou à paroi métallisée 31 situé approximativement au centre de l'emplacement du boîtier 14 de circuit intégré avec, au dessus le boîtier 14 de circuit intégré vu de côté et au dessous un pion métallique dissipateur thermique 40 vu en coupe.

Le substrat 10 est représenté étamé. Du côté du boîtier 14 de circuit intégré, il porte des plots de connexion 12 placés en regard de l'intersection des sabots rectangulaires de contact 23 et des plots extérieurs de connexion 22 du boîtier 14 de circuit intégré et, au centre des plots de connexion 12 qui dessinent la périphérie d'un rectangle, une plage étamable 32 de forme et taille comparables à celles de la plage étamable 24 du fond du boîtier 14 venant en regard. Du côté opposé au boîtier 14 de circuit intégré, le substrat 10 porte une autre plage étamable 33 qui communique avec la précédente 32 par le trou à paroi métallisée 31 et éventuellement, par d'autres trous à paroi métallisée, cela dépendant des surfaces des plages 32, 33. Du fait de l'étamage, le trou à paroi métallisée 31 est rempli de brasure tandis que les plots de connexion 12 et les plages étamables 32 et 33 sont recouverts de dômes de brasure 35, 36, 37.

Le pion dissipateur thermique 40 de forme cylindrique est brasé par une des ses bases 41 à la plage étamable 33 ici circulaire du substrat 10. Il est percé d'un canal axial se terminant du côté de cette base 41 par un capillaire 42 débouchant au voisinage du trou à paroi métallisée 31 du substrat 10 et du côté de la base opposée par un réservoir de brasure 43 de diamètre supérieur à celui du capillaire.

Lors de l'opération de refusion pendant laquelle le boîtier 14 de circuit intégré et le pion dissipateur thermique 40 sont appliqués de part de d'autre du substrat au niveau des dômes 36 et 37 recouvrant les plages étamables 32, 33, le pion dissipateur thermique ayant été traité au préalable par un flux décapant, l'excès de brasure contenu dans les dômes 36, 37 est aspiré grâce aux phénomènes de tension superficielle par la partie capillaire 42 du canal du pion et vient remplir la partie réservoir 43 comme représenté à la figure 4. Grâce à cela, le boîtier 14 de circuit intégré se plaque intimement à la surface du substrat et amène tous les sabots rectangulaires de contact 23 de ses plots extérieurs de connexion en contact avec les dômes de brasure 35 des plots de connexion du substrat 10 permettant dans tous les cas un brasage correct des plots de connexion 12 sans qu'il se forme de pont de brasure entre ces derniers et les plages étamables 24, 32.

La figure 5 montre en perspective le pion dissipateur thermique cylindrique 40. Celui-ci peut avoir un diamètre faible et présenter des bases de faible surface pour que sa brasure au substrat 10 soit fragile et puisse être facilement rompue dans le cas où le substrat 10 suffit à dissiper la chaleur engendrée par le boîtier 14 de circuit intégré.

Les figures 6, 7 et 8 montrent d'autres types de pions dissipateurs thermiques cylindriques ou tronconiques percés d'un ou plusieurs canaux coudés pour libérer la face opposée au substrat 10 et permettre de l'ouvrager par exemple pour réaliser des moyens de fixation à une plaque de dissipation thermique augmentant la surface de rayonnement.

La figure 6 représente en coupe un pion dissipateur thermique cylindrique 50 destiné à être brasé au substrat 10 par une base 51. Ce pion 50 est pourvu de quatre canaux coudés dont trois sont visibles, avec chacun un capillaire 52, 53, 54 débouchant sur la base 51 dans les coins d'un carré et un réservoir de brasure 55, 56, 57 débouchant dans la face latérale. La base 51′ du pion opposée au substrat est percée d'un trou borgne taraudé 58 servant de logement à une vis 58′ utilisée pour la fixation d'une plaque de dissipation thermique 59.

Les figures 7 et 8 montrent en coupe des pions de dissipation thermique de forme tronconique analogues à celui visible sur la figure 1, qui sont destinés à être brasés par leur petite base au substrat 10. Le pion 30 de la figure 7 est celui qui équipe le circuit hybride représenté à la figure 1. Il est percé d'un canal ramifié comportant un capillaire axial 61 débouchant extérieurement sur la petite base 62 destinée à être brasée au substrat 10 et, intérieurement, dans une chambre 63 placée au carrefour de plusieurs branches 64, 65, 66, 67 venant à angle droit, débouchant dans la paroi latérale du pion et servant de réservoir de brasure. Le pion 70 de la figure 8 est percé, comme celui de la figure 6, de quatre canaux coudés avec chacun un capillaire 71, 72, 73, 74 orienté dans l'axe du tronc de cône et débouchant dans la petite base 75 aux quatre coins d'un carré, et un réservoir de brasure 76, 77, 78, 79 orienté perpendiculairement à l'axe du tronc de cône et débouchant dans la paroi latérale.

On peut, sans sortir du cadre de l'invention modifier certaines dispositions ou remplacer certains moyens par des moyens équivalents. On peut notamment modifier la forme du pion dissipateur thermique en fonction des besoins et pourvoir sa surface extérieure d'ailettes ou de rainures comme cela est d'usage pour les radiateurs de semi-conducteurs. On peut également pourvoir la face du pion opposé au substrat de moyens de fixation autres qu'un orifice taraudé tels que, par exemple, un téton de rivetage ou une queue filetée qui n'ont pas l'inconvénient de nécessiter un enlèvement de matière diminuant l'inertie et la conductance thermique.

## Revendications

1. Procédé de refroidissement d'un boîtier (14) de circuit intégré pour montage sur un substrat (10), au moyen d'un dissipateur thermique, ledit boîtier et ledit dissipateur thermique étant fixés sur ledit substrat à un même emplacement de part et d'autre de celui-ci, caractérisé en ce qu'il consiste à:
- pourvoir la surface extérieure du fond du boîtier (14) de circuit intégré d'une plage étamable (24) permettant sa fixation par brasure,
- pourvoir le substrat (10), dans la zone de positionnement du boîtier (14) de circuit intégré, de deux plages étamables (32, 33) venant en vis-à-vis sur chacune de ses faces, la première plage étamable (32) étant placée en regard de celle (24) du fond du boîtier (14) de circuit intégré et la deuxième plage étamable (33) communiquant avec la première (32) par l'intermédiaire d'au moins un trou à paroi métallisée (31) percé au travers du substrat (10),
- étamer lesdites plages étamables, le ou les trous à paroi métallisée se remplissant alors de brasure,
- braser simultanément, sur le substrat (10), le fond du boîtier (14) de circuit intégré au moyen des plages étamables (24, 32) venant en regard et, sous le substrat (10), au niveau du boîtier (14) de circuit intégré, un pion dissipateur thermique (30, 40) pourvu d'une surface étamable (41) permettant son brasage sur la deuxième plage étamable (33) du substrat (10) et percé d'au moins un canal métallique se terminant à une extrémité par un capillaire (42) débouchant dans la surface étamable (41) et à l'autre extrémité par un réservoir de brasure (43), ce canal permettant d'absorber par l'intermédiaire du ou des trous à paroi métallisée (31) tout excès de brasure entre le fond du boîtier (14) de circuit intégré et le substrat (10).

2. Procédé selon la revendication 1, caractérisé en ce que le pion (40) est en contact avec le substrat par une surface petite rendant sa fixation par brasage au substrat (10) fragile et qu'il est séparé du substrat (10) après lui avoir été brasé par simple cassure.

3. Dispositif de refroidissement d'un boîtier (14) de circuit intégré comprenant un substrat (10), un boîtier (14) de circuit intégré et un dissipateur thermique (40), ledit boîtier et ledit dissipateur thermique étant fixés sur ledit substrat à un même emplacement de part et d'autre de celui-ci, caractérisé en ce que:
- au moins un trou à paroi métallisée (31) est percé au travers dudit substrat (10),
- ledit dissipateur thermique (40) est en forme de pion percé d'au moins un canal à paroi métallique se terminant à une extrémité par un capillaire (42) débouchant sur l'une des bases de ce pion et à l'autre extrémité par un réservoir de brasure (43),
- des plages étamables (24, 32, 33, 41) sont disposées en regard les unes des autres respectivement sur le fond du boîtier de circuit intégré, sur chacune des faces du substrat à l'endroit dudit au moins un trou à paroi métallisée, et sur celle des bases dudit pion dissipateur sur laquelle débouche ledit capillaire, lesdites plages étamables étant destinées à permettre la fixation, par brasure, de ladite base du pion dissipateur thermique, au fond dudit boîtier.

4. Dispositif selon la revendication 3, caractérisé en ce que ledit pion dissipateur thermique (50) est percé d'au moins un canal coudé comportant un capillaire (52, 53, 54) débouchant sur la face (51) en regard du substrat et un réservoir de brasure (55, 56, 57) débouchant sur une face latérale dudit pion (50) pour laisser libre la face (51′) de ce dernier tournée à l'opposé de substrat.

5. Dispositif selon la revendication 3, caractérisé en ce que ledit pion dissipateur thermique (30) est percé d'un canal ramifié comportant un capillaire (61) débouchant à l'extérieur du pion (30) dans la face (62) tournée vers le substrat (10) et, à l'intérieur du pion (30), dans une chambre (63) placée au carrefour de plusieurs branches (64, 65, 66, 67) constituant des réservoirs de brasure et débouchant dans la face latérale.

6. Dispositif selon la revendication 4, caractérisé en ce que ledit pion dissipateur thermique (70) est percé de plusieurs canaux coudés dont les capillaires (71, 72, 73, 74) débouchent à l'extérieur du pion (70) dans les coins d'un carré sur la face (75) tournée vers le substrat (10) et dont les réservoirs de brasure (76, 77, 78, 79) débouchent sur le pourtour de la face latérale du pion (70).

7. Dispositif selon la revendication 3, caractérisé en ce que ledit pion dissipateur thermique (50) comporte sur sa face (51′) tournée à l'opposé du substrat (10) des moyens de fixation (58, 58′) à une plaque de dissipation thermique (59).

8. Dispositif selon la revendication 3, caractérisé en ce que ledit pion dissipateur thermique (40) est cylindrique.

9. Dispositif selon la revendication 3, caractérisé en ce que ledit pion dissipateur thermique (30, 70) est tronconique.

## Patentansprüche

1. Verfahren zum Kühlen eines IC-Gehäuses (14), das auf einem Substrat (10) befestigt werden soll, mit Hilfe eines Wärmeabfuhrelements, wobei das Gehäuse und das Wärmeabfuhrelement auf dem Substrat an derselben Stelle zu beiden Seiten des Substrats befestigt sind,
dadurch gekennzeichnet, daß das Verfahren darin besteht:
- die äußere Oberfläche des Bodens des IC-Gehäuses (14) mit einem verzinnbaren Bereich (24) zu versehen, der ihre Befestigung durch Lötung ermöglicht,
- das Substrat (10) in der Bestückungszone des IC-Gehäuses (14) mit zwei verzinnbaren Bereichen (32, 33) zu versehen, die auf beiden Seiten des Substrats deckungsgleich einander gegenüberliegen, wobei der erste verzinnbare Bereich (32) gegenüber demjenigen (24) des Bodens des IC-Gehäuses (14) liegt und der zweite verzinnbare Bereich (33) mit dem ersten (32) über mindestens ein Loch mit metallisierter Oberfläche (31) verbunden ist, das durch das Substrat (10) verläuft,
- die verzinnbaren Bereiche zu verzinnen, wobei sich das metallisierte Loch bzw. die metallisierten Löcher mit Lot füllen,
- gleichzeitig mit Hilfe der übereinanderliegenden verzinnbaren Bereiche auf dem Substrat (10) den Boden des IC-Gehäuses (14) bzw. unter dem Substrat (10) in Höhe des IC-Gehäuses (14) ein Wärmeabfuhrklötzchen (30, 40) anzulöten, das mit einer verzinnbaren Oberfläche (41) versehen ist, die ihr Anlöten am zweiten verzinnbaren Bereich (33) des Substrats (10) ermöglicht, wobei das Klötzchen mindestens einen metallischen Kanal aufweist, der an einem Ende in einer Kapillare (42), die in die verzinnbare Oberfläche (41) mündet, und am anderen Ende in einem Lotreservoir endet, wobei der Kanal durch das Loch bzw. durch die Löcher (31) mit metallisierter Wand jeden Überschuß an Lot zwischen dem Boden des IC-Gehäuses (14) und dem Substrat (10) aufnehmen kann.

2. Verfahren nach Anspruch 1, dadurch gekennzeichnet, daß das Klötzchen (40) durch eine kleine Oberfläche, die seine Befestigung durch Anlöten auf dem Substrat (10) zerbrechlich macht, in Berührung steht und das vom Substrat (10) durch einfaches Abbrechen abgelöst wird, nachdem es auf dem Substrat angelötet worden war.

3. Vorrichtung zum Kühlen eines IC-Gehäuses (14), die ein Substrat (10), ein IC-Gehäuse (14) und ein Wärmeabfuhrelement (40) aufweist, wobei das Gehäuse und das Wärmeabfuhrelement auf dem Substrat an derselben Stelle zu beiden Seiten des Substrats befestigt sind, dadurch gekennzeichnet, daß
- mindestens ein Loch (31) mit metallisierter Wand durch das Substrat (10) verläuft,
- das Wärmeabfuhrelement (40) die Form eines Klötzchens aufweist, das von mindestens einem Kanal mit metallisierter Wand durchdrungen wird, der an einem Ende in einer Kapillare (42), welche an einer der Basisflächen des Klötzchens mündet, und am anderen Ende in einem Lotreservoir (43) endet,
- verzinnbare Bereiche (24, 32, 33, 41) deckungsgleich einander gegenüberliegend auf dem Boden des IC-Gehäuses, auf jeder der Seiten des Substrats an der Stelle des mindestens einen Lochs mit metallisierter Wand und auf derjenigen Seite der Basisflächen des Wärmeabfuhrklötzchens angeordnet sind, an der die Kapillare mündet, wobei die verzinnbaren Bereiche dazu bestimmt sind, durch Verlötung die Befestigung dieser Basisfläche des Wärmeabfuhrklötzchens am Boden des Gehäuses zu ermöglichen.

4. Vorrichtung nach Anspruch 3, dadurch gekennzeichnet, daß das Wärmeabfuhrklötzchen (50) von mindestens einem geknickten Kanal durchdrungen wird, der eine Kapillare (52, 53, 54), die an der Fläche (51) gegenüber dem Substrat mündet, und ein Lotreservoir (55, 56, 57) aufweist, das an einer Seitenfläche des Klötzchens (50) mündet, um die dem Substrat abgewandte Fläche (51′) des letzteren unberührt zu lassen.

5. Vorrichtung nach Anspruch 3, dadurch gekennzeichnet, daß das Wärmeabfuhrklötzchen (30) von einem verzweigten Kanal durchdrungen ist, der eine Kapillare (61) aufweist, die an der Außenseite des Klötzchens (30) in der dem Substrat (10) abgekehrten Fläche (62) und im Inneren des Klötzchens (30) in eine Kammer (63) mündet, die in der Kreuzung mehrerer Zweige (64, 65, 66, 67) mündet, die Lotreservoire bilden und in der Seitenfläche münden.

6. Vorrichtung nach Anspruch 4, dadurch gekennzeichnet, daß das Wärmeabfuhrklötzchen (70) von mehreren geknickten Kanälen durchdrungen ist, deren Kapillaren (71, 72, 73, 74) an der Außenseite des Klötzchens (70) in den Ecken eines Quadrates in der dem Substrat (10) zugekehrten Fläche (75) münden und deren Lotreservoire (76, 77, 78, 79) am Umfang der Seitenfläche des Klötzchens (70) münden.

7. Vorrichtung nach Anspruch 3, dadurch gekennzeichnet, daß das Wärmeabfuhrklötzchen (50) auf seiner dem Substrat (10) abgewandten Fläche (51′) Mittel (58, 58′) zur Befestigung einer Wärmeabfuhrplatte (59) aufweisen.

8. Vorrichtung nach Anspruch 3, dadurch gekennzeichnet, daß das Wärmeabfuhrklötzchen (40) zylindrisch ist.

9. Vorrichtung nach Anspruch 3, dadurch gekennzeichnet, daß das Wärmeabfuhrklötzchen (30, 70) kegelstumpfförmig ist.

## Claims

1. A method of using a heat-dissipator to cool an integrated circuit package (14) for mounting on a substrate (10), said package and said heat-dissipator being fixed on said substrate at the same position and on opposite sides thereof, the method being characterized in that it consists in:
providing the outside surface of the bottom of the integrated circuit package (14) with a tinnable area (24) suitable for fixing by soldering;
providing the substrate (10) in the zone where the integrated circuit package (14) is to be positioned, with two tinnable areas (32, 33) coinciding on opposite faces of the substrate, with the first tinnable area (32) being placed facing the tinnable area (24) on the bottom of the integrated circuit package (14) and with the second tinnable area (33) communicating with the first (32) via at least one plated-through hole (31) going through the substrate (10);
tinning said tinnable areas, the plated-through hole or holes thus filling with solder; and
soldering the bottom of the integrated circuit package (14) on top of the substrate (10) by means of the tinnable areas (24, 32) being brought face to face, and soldering a heat-dissipating peg (30, 40) underneath the substrate (10) level with the integrated circuit package (14), the peg having a tinnable surface (41) enabling it to be soldered to the second tinnable area (33) of the substrate (10), and being pierced by at least one metal-walled channel terminating at one end in a capillary (42) which opens out into the tinnable surface (41) and terminating at its other end by a solder receptacle (43), said channel serving to absorb any excess solder between the substrate (10) and the bottom of the integrated circuit package (14) via the, or each, plated-through hole (31).

2. A method according to claim 1, characterized in that the peg (40) comes into contact with the substrate via a small area so that its connection to the substrate (10) by soldering is fragile, and in that it is separated from the substrate (10) after being soldered thereto, merely by breaking.

3. A device for cooling an integrated circuit package (14) comprising a substrate (10), an integrated circuit package (14) and a heat-dissipator (40) said package and said heat-dissipator being fixed on said substrate at the same position and on opposite sides thereof, the device being characterized in that:
at least one plated-through hole (31) goes through said substrate (10);
said heat-dissipator (40) is in the form of a peg pierced by at least one metal-walled channel terminating at one end by a capillary (42) opening out to one of the bases of said peg and at its other end by a solder receptacle (43);
tinnable areas (24, 32, 33, 41) are disposed facing each other respectively on the bottom of the integrated circuit package on each surface of the substrate at the position of at least one plated-through hole, and on the bases of said dissipator peg to which said capillary opens out, said tinnable areas being suitable for fixing said base of the heat-dissipator peg to the bottom of said package by soldering.

4. A device according to claim 3, characterized in that said heat-dissipating peg (50) is pierced by at least one angled channel comprising a capillary (52, 53, 54) opening out into the face (51) facing the substrate, and a solder receptacle (55, 56, 57) opening out into a side face of said peg (50) in order to avoid occupying the face (51′) of the peg which faces away from the substrate.

5. A device according to claim 3, characterized in that said heat-dissipating peg (30) is pierced by a branching channel including a capillary (61) opening out to the outside of the peg (30) in its face (62) which faces the substrate (10), and opening out inside the peg (30) into a chamber (63) placed at the intersection between a plurality of branches (64, 65, 66, 67) constituting solder receptacles and opening out into the side face of the peg.

6. A device according to claim 4, characterized in that said heat-dissipating peg (70) is pierced by a plurality of angled channels whose capillaries (71, 72, 73, 74) open out at their outside ends at the corners of a square in the face (75) of the peg (70) facing the substrate (10), and whose solder receptacles (76, 77, 78, 79) open out around the side face of the peg (70).

7. A device according to claim 3, characterized in that said heat-dissipating peg (50) includes fixing means (58, 58′) in its face (51′) facing away from the substrate (10), said fixing means serving to fix it to a heat-dissipating plate (59).

8. A device according to claim 3, characterized in that said heat-dissipating peg (40) is cylindrical.

9. A device according to claim 3, characterized in that said heat-dissipating peg (30, 70) is frustoconical.
